# EUROPÄISCHE PATENTSCHRIFT

(11) **EP 2 898 760 B1**
(45) Veröffentlichungstag und Bekanntmachung des Hinweises auf die Patenterteilung: **30.11.2016**
(21) Anmeldenummer: 13724736.7
(22) Anmeldetag: 15.05.2013
(51) Int. Cl.: H05K 5/00, F16B 21/12, F16B 5/06

(54) **BAUKASTEN MIT ZWEI, AN BENACHBARTEN GEHÄUSESEITEN ANEINANDER ANLIEGENDEN GEHÄUSEN**
MODULAR KIT COMPRISING TWO HOUSINGS RESTING ON EACH OTHER ON ADJACENT HOUSING SIDES
ENSEMBLE MODULABLE COMPORTANT DEUX BOÎTIERS QUI SE TOUCHENT PAR DES FACES DE BOÎTIER ADJACENTES

(30) Priorität: 21.09.2012 DE 202012009118 U
(43) Veröffentlichungstag der Anmeldung: 29.07.2015
(73) Patentinhaber: Pyramid Computer GmbH, 79111 Freiburg (DE)
(72) Erfinder: HANSEN, Friedrich, 79102 Freiburg (DE)
(74) Vertreter: Börjes-Pestalozza, Henrich
(86) Internationale Anmeldenummer: PCT/EP2013/001437
(87) Internationale Veröffentlichungsnummer: WO 2014/044336

(56) Entgegenhaltungen:
- EP-A2- 1 333 333
- US-A- 3 661 048
- US-A- 5 194 693
- US-A1- 2012 079 791

## Beschreibung

Die Erfindung betrifft einen Baukasten mit zumindest zwei Gehäusen, die an benachbarten, aneinander anliegenden Gehäuseseiten mittels wenigstens einem Verbinder miteinander lösbar verbindbar sind.

Aus der EP 1 333 333 A2 ist eine Vorrichtung zum lösbaren Verbinden eines ersten Moduls einer Büromaschine mit einem zweiten Modul einer Büromaschine vorbekannt. Die beiden Module der Büromaschine können mittels einer Steckverbindung miteinander verbunden werden. Zur Sicherung der Steckverbindung sind Sicherungsschrauben vorgesehen, die seitlich in die einzelnen Verbindungsstellen eingeschraubt werden.

Datenverarbeitungsanlagen bestehen regelmäßig aus verschiedenen Komponenten, wie zum Beispiel Bildschirm, Drucker, Tastatur oder dergleichen. Diese Komponenten sind zumindest teilweise in getrennten Gehäusen untergebracht. An Arbeitsplätzen, wie beispielsweise an Kartenverkaufsstellen und dergleichen, kann es zweckmäßig sein, die jeweils benötigten Bestandteile einer Datenverarbeitungsanlage zu einer kompakten Einheit zusammenzufassen.

Es besteht daher insbesondere die Aufgabe, einen Baukasten der eingangs erwähnten Art zu schaffen, der es ermöglicht, zumindest zwei benachbarte, aneinander anliegende Gehäuse mittels wenigstens einem Verbinder rasch und mit geringem Aufwand fest aneinander zu fixieren.

Die erfindungsgemäße Lösung dieser Aufgabe besteht in den Merkmalen des geltenden Patentanspruchs 1.

Der erfindungsgemäße Baukasten weist zumindest zwei Gehäuse auf, die beispielsweise die Gerätegehäuse eines Bildschirms, einer Bedieneinheit, eines Ticketdruckers, eines Kartenlesers oder dergleichen Bestandteile einer gegebenenfalls auch individuell zusammengestellten Datenverarbeitungsanlage sein können. Die zumindest zwei Gehäuse des erfindungsgemäßen Baukastens sind an benachbarten, aneinander anliegenden Gehäuseseiten mittels wenigstens einem Verbinder miteinander lösbar verbindbar. Dieser Verbinder weist ein Verbindungselement auf, das an dem ersten der beiden miteinander verbindbaren Gehäuse vorgesehen ist und zumindest zwei voneinander beabstandete Verbindungsstege hat. An den Verbindungsstegen sind einander zugeordnete Sicherungsöffnungen vorgesehen. Bei der Montage der Gehäuse sind die Verbindungsstege derart in Relation zu einem im zweiten Gehäuse befindlichen Gegenelement zu positionieren, dass ein in die Sicherungsöffnungen eingeschobener Sicherungssplint oder Sicherungsstab zumindest einen zwischen den Verbindungsstegen positionierten Durchsteckkanal des Gegenelements durchsetzt. In dem im Gegenelement umgrenzten Durchsteckkanal ist der Sicherungssplint oder Sicherungsstab in axialer Richtung der Verbindungsstege mit einem einstellbaren Spiel gehalten, derart, dass durch eine Verringerung des Spiels die Gehäuse zunehmend aneinander gepresst und sicher miteinander verbunden werden können. In einer rechtwinklig zum Sicherungssplint oder Sicherungsstab und auch rechtwinklig zur Längserstreckung der Verbindungsstege orientierten Richtung ist der Sicherungssplint oder Sicherungsstab demgegenüber im wesentlichen spielfrei gehalten, so dass der Verbinder die Gehäuse auch in dieser Richtung sicher und fest miteinander verbindet.

Zweckmäßig ist es, wenn in dem zweiten Gehäuse jeweils einem Verbindungssteg zugeordnete und in den Bereich des zumindest einen, im zweiten Gehäuse angeordneten Gegenelements führende Führungsschlitze vorgesehen sind. Diese Ausführung sieht vor, dass das das Gegenelement zumindest eines Verbinders in sich aufnehmende zweite Gehäuse wenigstens zwei, das zweite Gehäuse durchbrechende Führungsschlitze hat, die jeweils einem der Verbindungsstege eines Verbinders zugeordnet sind und in den Bereich des im Gehäuseinneren des zweiten Gehäuses befindlichen Gegenelements führen. Bei dieser Ausführungsform werden die Verbindungsstege in die Führungsschlitze eingeschoben, bis der Sicherungssplint oder Sicherungsstab die Verbindungsstege und das Gegenelement miteinander verbinden kann.

Eine besonders vorteilhafte Weiterbildung gemäß der Erfindung sieht vor, dass der Sicherungssplint oder Sicherungsstab an seinem dem Verbindungselement zugewandten Längsrand eine Auflaufkontur hat, dass entlang diesem Längsrand und der Auflaufkontur ein Sicherungsschieber im Gegenelement verschieblich geführt ist, und dass durch ein Verschieben des an der Auflaufkontur verschieblich geführten Sicherungsschiebers das Spiel des Sicherungssplintes vorzugsweise bis auf Null einstellbar ist. Der Sicherungssplint oder Sicherungsstab weist an seinem dem Verbindungselement zugewandten Längsrand eine Auflaufkontur auf. Im Gegenelement ist ein Sicherungsschieber vorgesehen, der an dem dem Verbindungselement zugewandte Längsrand und entlang der dort vorgesehen Auflaufkontur verschieblich geführt ist. Durch ein Verschieben des Sicherungsschiebers entlang dem Längsrand des die Sicherungsöffnungen und den Durchsteckkanal durchsetzenden Sicherungssplints lässt sich das Spiel des Sicherungssplints derart verringern, dass die Gehäuse mit ihren benachbarten Gehäuseseiten fest aneinander anliegen.

Zweckmäßig ist es, wenn am Gegenelement ein Widerlager mit einer Gewindebohrung vorgesehen ist, in welche Gewindebohrung eine Stellschraube eingreift, die eine Durchtrittsöffnung am Sicherungsschieber durchsetzt. Bei dieser Ausführung ist am Gegenelement ein Widerlager mit einer Gewindebohrung vorgesehen. In die Gewindebohrung ist eine Stellschraube eingeschraubt, die die Durchtrittsöffnung am Sicherungsschieber durchsetzt, derart, dass der Sicherungsschieber im Bereich seiner Durchtrittsöffnung zwischen dem Schraubenkopf und dem Widerlager angeordnet ist. Durch Einschrauben der Stellschraube in die Gewindebohrung des Widerlagers wird der Abstand auch zwischen Sicherungsschieber und Widerlager derart verringert, dass der Sicherungsschieber auf dem Gegenelement entlang dem Längsrand des Sicherungssplints oder Sicherungsstabs verschoben wird.

Um die einfache Handhabung des erfindungsgemäßen verwendeten Verbinders noch zusätzlich zu begünstigen, kann es zweckmäßig sein, wenn am Sicherungssplint ein Einsetzanschlag vorgesehen ist, der den Einsetzweg des Sicherungssplints in den Sicherungsöffnungen begrenzt und der vorzugsweise mit dem die Sicherungsöffnung umgrenzenden Randbereich des in Einsetzrichtung vorderen Verbindungssteges zusammenwirkt.

Um den erfindungsgemäß vorgesehenen Verbinder des Baukastens möglichst einfach und kostengünstig herstellen zu können, ist es vorteilhaft, wenn das Verbindungselement und/oder das Gegenelement des zumindest einen Verbinders als metallenes Biegeformteil hergestellt ist.

Dabei sieht eine bevorzugte Ausführungsform gemäß der Erfindung vor, dass das Verbindungselement als U-förmiges Biegeformteil hergestellt ist, dessen freien U-Stege als Verbindungsstege ausgebildet sind.

Der Durchsteckkanal im Gegenelement, durch den der Sicherungssplint oder Sicherungsstab in das Gegenelement eingeschoben wird, muss nicht in Kanallängserstreckung allseits umschlossen sein. Vielmehr kann der Durchsteckkanal des Gegenelements durch Führungsflächen begrenzt sein, wobei die Führungsflächen vorzugsweise durch Umbiegungen des als Biegeformteil hergestellten Gegenelements gebildet sind.

Um die miteinander zu verbindenden Gehäuse positionsgenau aneinander fixieren zu können, ist es zweckmäßig, wenn an den aneinander anliegenden Seiten der Gehäuse das eine Gehäuse zumindest einen und vorzugsweise wenigstens zwei voneinander beanstandete Positioniervorsprünge aufweist, die in eine komplementäre Positioniereinformung am anderen Gehäuse eingreifen.

Ein bevorzugtes Anwendungsbeispiel sieht vor, dass die Gehäuse die Gerätegehäuse einer aus zumindest zwei Geräten zusammengesetzten Datenverarbeitungsanlagen sind.

Weiterbildungen gemäß der Erfindung ergeben sich aus den Zeichnungen in Verbindung mit den Ansprüchen sowie der Figurenbeschreibung. Nachstehend werden die wesentlichen Merkmale der Erfindung anhand eines bevorzugten Ausführungsbeispieles noch näher erläutert.

Es zeigt:
- Figur 1:: zwei zu einem Baukasten gehörende Gehäuse, die an benachbarten, aneinander anliegenden Seiten mittels zumindest einem Verbinder lösbar verbindbar sind, wobei die Gehäuse hier in einer noch voneinander beabstandeten Bereitschaftsstellung in einem Detail-Längsschnitt gezeigt sind,
- Figur 2:: die beiden Gehäuse aus Figur 1 in einem Detail-Längsschnitt, wobei die Gehäuse mit Hilfe des Verbinders bereits miteinander verbunden sind, und
- Figur 3:: den in den Gehäusen gemäß Figur 1 und 2 verwendeten Verbinder in einer perspektivischen Darstellung.

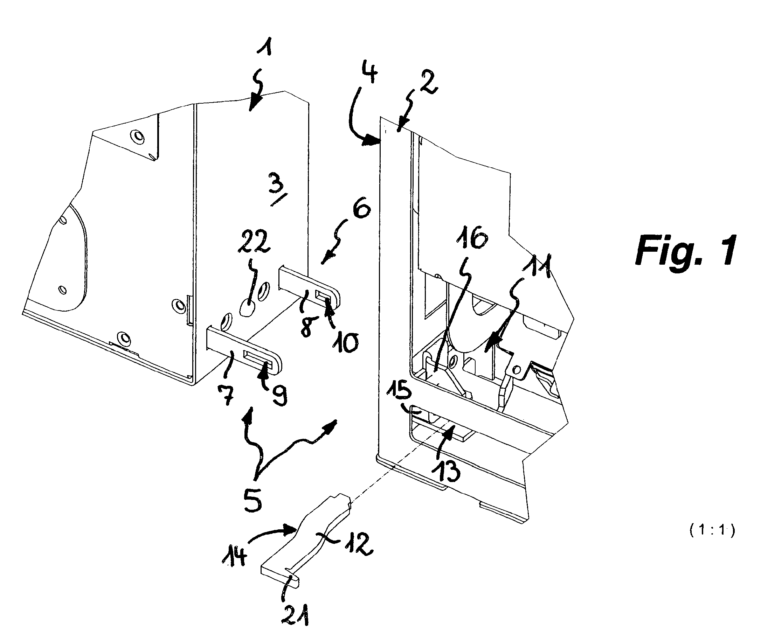

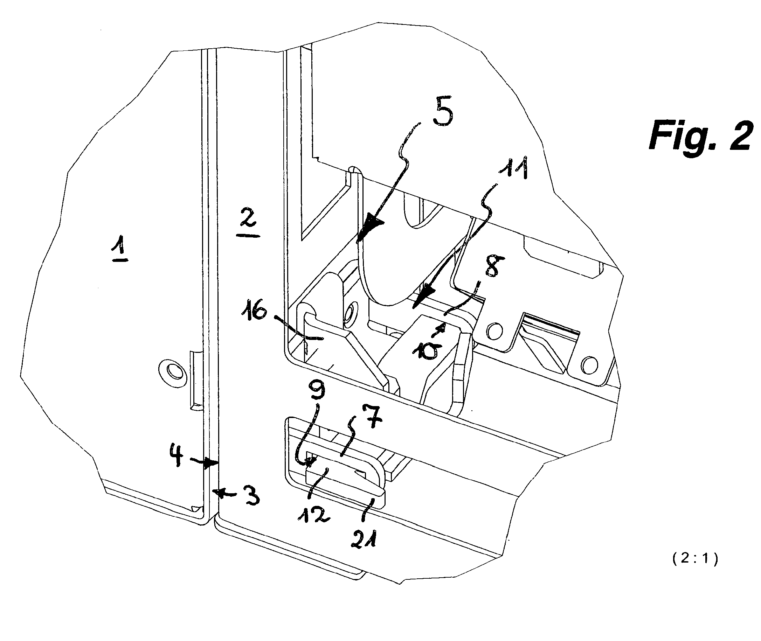

In den Figuren 1 und 2 sind zwei Gehäuse 1, 2 dargestellt, die Bestandteile eines Baukastens bilden, der gegebenenfalls auch weitere Gehäuse mit anderen Funktionen umfasst. Diese Gehäuse des Baukastens können die Gerätegehäuse eines Bildschirms, einer Bedieneinheit, eines Ticketdruckers, eines Kartenlesers oder dergleichen Bestandteil einer gegebenenfalls auch individuell zusammengestellten Datenverarbeitungsanlage sein. Die Gehäuse 1, 2, die in ihrer Tiefe und gegebenenfalls auch in ihrer Höhe und/oder Breite übereinstimmende Gehäuse-Schmalseiten haben, sind an ihren benachbarten, aneinander anliegenden Gehäuseseiten 3, 4 mittels wenigstens einem Verbinder 5 miteinander lösbar verbindbar. Der Verbinder 5 weist ein Verbindungselement 6 auf, das an dem ersten Gehäuse 1 vorgesehen ist und zumindest zwei voneinander beabstandete Verbindungsstege 7, 8 hat. An den Verbindungsstegen 7, 8 sind einander zugeordnete Sicherungsöffnungen 9, 10 vorgesehen. Bei der Montage der Gehäuse 1, 2 sind die Verbindungsstege 7, 8 derart in Relation zu einem im zweiten Gehäuse 2 befindlichen Gegenelement 11 zu positionieren, dass ein die Sicherungsöffnungen 9, 10 eingeschobener Sicherungssplint oder Sicherungsstab 12 zumindest einen zwischen den Verbindungsstegen 7, 8 positionierten Durchsteckkanal 13 des Gegenelements 11 durchsetzt. In dem im Gegenelement 11 umgrenzten Durchsteckkanal 13 ist der Sicherungssplint oder Sicherungsstab 12 in axialer Richtung der Verbindungsstege 7, 8 mit einem einstellbaren Spiel gehalten, derart, dass durch eine Verringerung des Spiels die Gehäuse 1, 2 zunehmend aneinander gepresst und sicher miteinander verbunden werden können. In einer rechtwinklig zum Sicherungssplint oder Sicherungsstab 12 und auch rechtwinklig zur Längserstreckung der Verbindungsstege 7, 8 orientierten Richtung ist der Sicherungssplint oder Sicherungsstab 12 demgegenüber im wesentlichen spielfrei gehalten, so dass der Verbinder 5 die Gehäuse 1, 2 auch in dieser Richtung sicher und fest miteinander verbindet.

In dem zweiten Gehäuse sind jeweils einem Verbindungssteg 7, 8 zugeordnete Führungsschlitze vorgesehen, die in den Bereich des zumindest einen, im zweiten Gehäuse 2 angeordneten Gegenelements 11 führen. Das zweite Gehäuse 2, dass den zumindest einen Verbinder 5 in sich aufnimmt, weist wenigstens zwei, das Gehäuse durchbrechende Führungsschlitze auf, die jeweils einem der Verbindungsstege 7, 8 zugeordnet sind und zu dem im Inneren des Gehäuses 2 befindlichen Gegenelement 11 führen.

Das Verbindungselement 6 und das Gegenelement 11 des zumindest einen Verbinders 5 ist als metallenes Biegeformteil hergestellt. Während das Verbindungselement 6 hier als U-förmiges Biegeformteil hergestellt ist, dessen freien U-Stege als die Verbindungsstege 7, 8 ausgebildet sind, wird der Durchsteckkanal 13 im Gegenelement durch Führungsflächen begrenzt, die durch Umbiegungen des ebenfalls als Biegeformteil hergestellten Gegenelements 11 gebildet sind.

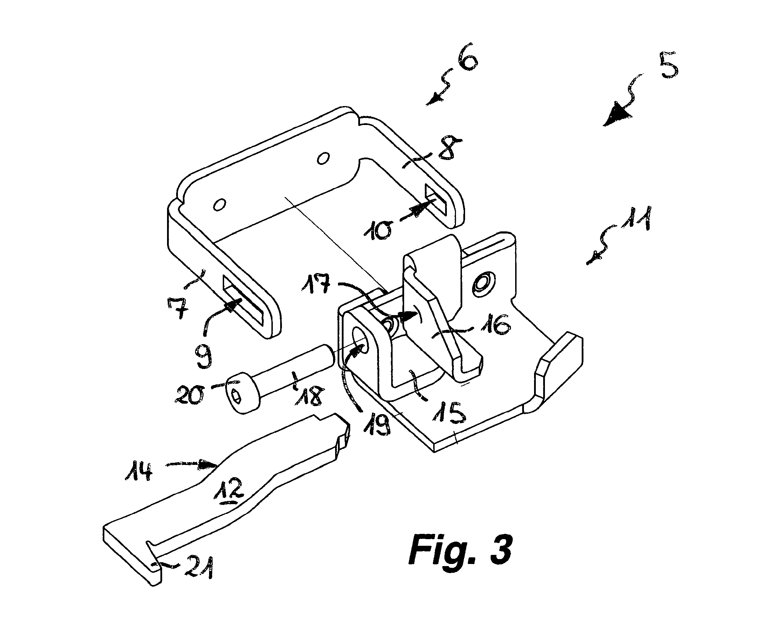

In Figur 3 ist erkennbar, dass der Sicherungssplint oder Sicherungsstab 12 an seinem dem Verbindungselement 6 zugewandten Längsrand eine Auflaufkontur 14 hat. Entlang dem Längsrand und der am Längsrand vorgesehenen Auflaufkontur 14 ist ein Sicherungsschieber 15 im Gegenelement 11 verschieblich geführt. Durch ein Verschieben des an der Auflaufkontur 14 verschieblich geführten Sicherungsschiebers 15 ist das Spiel des Sicherungssplintes oder Sicherungsstabes 12 gegebenenfalls bis auf Null einstellbar. Durch eine Reduktion des Spiels können die Gehäuse 1, 2 an ihren aneinander zugewandten Gehäuseseiten gegeneinander gepresst werden und sind somit sicher und fest miteinander verbunden.

Am Gegenelement 11 ist ein Widerlager 16 mit einer Gewindebohrung 17 vorgesehen, in welche Gewindebohrung eine hier als Innensechskantschraube ausgebildete Stellschraube 18 eingreift. Diese Stellschraube 18 durchsetzt eine Durchtrittsöffnung an dem hier L-förmig ausgebildeten Sicherungsschieber 15, so dass der die Durchtrittsöffnung 19 umgrenzende Teilbereich des Sicherungsschiebers 15 zwischen dem Schraubenkopf 20 und dem Widerlager 16 angeordnet ist. Durch ein Einschrauben der Stellschraube 18 in die am Widerlager 16 vorgesehene Gewindebohrung 17 wird der Abstand zwischen dem Schraubenkopf 20 und somit zwischen dem die Durchtrittsöffnung 19 aufweisenden Teilbereich des Sicherungsschiebers 15 in Relation zum Widerlager 16 derart verringert, dass die über den Sicherungsschieber 15 auf den Sicherungssplint oder Sicherungsstab 12 ausgeübte Stellkraft die Verbindungsstege 7, 8 des Verbindungselements 6 noch tiefer in das Gehäuseinnere des zweiten Gehäuses 2 zieht.

In Figur 3 ist besonders deutlich erkennbar, dass am Sicherungssplint oder Sicherungsstab 12 ein Einsetzanschlag 21 vorgesehen ist, der den Einsetzweg des Sicherungssplints oder Sicherungsstabes 12 in den Sicherungsöffnungen 9, 10 begrenzt. Dieser Einsetzanschlag 21, der als hakenförmiger Vorsprung am Sicherungssplint oder Sicherungsstab 12 ausgebildet ist, wirkt mit dem die Sicherungsöffnung 9 umgrenzenden Randbereich des in Einsetzrichtung vorderen Verbindungssteges 7 zusammen.

In Figur 1 ist angedeutet, dass an den aneinander anliegenden Seiten der Gehäuse 1, 2 das eine Gehäuse 1 zumindest einen Positioniervorsprung 22 aufweist, der in eine komplementäre Positioniereinformung am anderen Gehäuse 2 eingreift. Durch diesen, an dem einen Gehäuse 1 vorgesehenen Positioniervorsprung 22, der in eine Positioniereinformung am anderen Gehäuse 2 eingreift, wird der sichere und positionsgerechte Halt der mit ihren Gehäuse-Schmalseiten aneinander anliegenden Gehäuse 1, 2 noch zusätzlich begünstigt.

Die Gehäuse 1, 2 weisen hier eine im wesentlichen rechteckige Außenkontur auf; aufgrund ihrer vergleichsweisen geringen Tiefe sind die Gehäuse 1, 2 brett- oder tafelförmig ausgebildet. An den übrigen Gehäuseschmalseiten der Gehäuse 1, 2 können bei Bedarf auch weitere, hier nicht weiter dargestellte Gehäuse befestigt werden, sofern auch an zumindest einer der übrigen Gehäuseschmalseiten wenigstens ein Verbinder 5 vorgesehen ist.

### Bezugszeichenliste

- 1: (Erstes) Gehäuse
- 2: (Zweites) Gehäuse
- 3: Gehäuseseite (des Gehäuses 1)
- 4: Gehäuseseite (des Gehäuses 2)
- 5: Verbinder
- 6: Verbindungselement
- 7: Verbindungssteg
- 8: Verbindungssteg
- 9: Sicherungsöffnung (am Verbindungssteg 7)
- 10: Sicherungsöffnung (am Verbindungssteg 8)
- 11: Gegenelement
- 12: Sicherungssplint oder Sicherungsstab
- 13: Durchsteckkanal (im Gegenelement 11)
- 14: Auflaufkontur (am Sicherungssplint 12)
- 15: Sicherungsschieber (im Gegenelement 11)
- 16: Widerlager (am Gegenelement 11)
- 17: Gewindebohrung (am Widerlager 16)
- 18: Stellschraube
- 19: Durchtrittsöffnung (am Sicherungsschieber 15)
- 20: Schraubenkopf (der Stellschraube 18)
- 21: Einsetzanschlag (am Sicherungssplint 12)
- 22: Positioniervorsprung (an der Gehäuseseite 3)

## Patentansprüche

1. Baukasten mit zumindest zwei Gehäusen (1, 2), die an benachbarten, aneinander anliegenden Seiten (3, 4) mittels wenigstens einem Verbinder (5) miteinander lösbar verbindbar sind, welcher Verbinder (5) ein an dem ersten Gehäuse (1) vorgesehenes Verbindungselement (6) aufweist, das (6) zumindest zwei voneinander beabstandete Verbindungsstege (7, 8) mit einander zugeordneten Sicherungsöffnungen (9, 10) hat, welche Verbindungsstege (7, 8) derart in Relation zu einem im zweiten Gehäuse (2) vorgesehenen Gegenelement (11) positionierbar sind, dass ein in die Sicherungsöffnungen (9, 10) eingeschobener Sicherungssplint oder Sicherungsstab (12) zumindest einen zwischen den Verbindungsstegen (7, 8) angeordneten Durchsteckkanal (13) des Gegenelements (11) durchsetzt und darin in axialer Richtung der Verbindungsstege (7, 8) mit einstellbarem Spiel und in einer rechtwinklig zum Sicherungssplint oder Sicherungsstab (12) sowie zur Längserstreckung der Verbindungsstege (7, 8) orientierten Richtung im wesentlichen spielfrei gehalten ist, wobei die Gehäuse (1, 2) durch eine Verringerung des einstellbaren Spiels zunehmend aneinander pressbar und sicher miteinander verbindbar sind.

2. Baukasten nach Anspruch 1, **dadurch gekennzeichnet, dass** in dem zweiten Gehäuse (2) jeweils einem Verbindungssteg (7, 8) zugeordnete und in den Bereich des zumindest einen, im zweiten Gehäuse (2) angeordneten Gegenelements (11) führende Führungsschlitze vorgesehen sind.

3. Baukasten nach Anspruch 1 oder 2, **dadurch gekennzeichnet, dass** der Sicherungssplint oder Sicherungsstab (12) an seinem dem Verbindungselement (6) zugewandten Längsrand eine Auflaufkontur (14) hat, dass entlang diesem Längsrand und der Auflaufkontur (14) ein Sicherungsschieber (15) im Gegenelement (11) verschieblich geführt ist, und dass durch ein Verschieben des in der Auflaufkontur (14) verschieblich geführten Sicherungsschiebers (15) das Spiel des Sicherungssplintes oder Sicherungsstabes (12) vorzugsweise bis auf Null einstellbar ist.

4. Baukasten nach Anspruch 3, **dadurch gekennzeichnet, dass** am Gegenelement (11) ein Widerlager (16) mit einer Gewindebohrung (17) vorgesehen ist, in welche Gewindebohrung (17) eine Stellschraube (18) eingreift, die (18) eine Durchtrittsöffnung (19) am Sicherungsschieber (15) durchsetzt.

5. Baukasten nach einem der Ansprüche 1 bis 4, **dadurch gekennzeichnet, dass** am Sicherungssplint oder Sicherungsstab (12) ein Einsetzanschlag (21) vorgesehen ist, der den Einsetzweg des Sicherungssplints oder Sicherungsstabes (12) in den Sicherungsöffnungen (9, 10) begrenzt und der vorzugsweise mit dem die Sicherungsöffnung (9) umgrenzenden Randbereich des in Einsetzrichtung vorderen Verbindungssteges (7) zusammenwirkt.

6. Baukasten nach einem der Ansprüche 1 bis 5, **dadurch gekennzeichnet, dass** das Verbindungselement (6) und/oder das Gegenelement (11) des zumindest einen Verbinders (5) als metallenes Biegeformteil hergestellt ist.

7. Baukasten nach Anspruch 6, **dadurch gekennzeichnet, dass** das Verbindungselement (6) als u-förmiges Biegeformteil hergestellt ist, dessen freien U-Stege als Verbindungsstege (7, 8) ausgebildet sind.

8. Baukasten nach Anspruch 6 oder 7, **dadurch gekennzeichnet, dass** der Durchsteckkanal (13) des Gegenelements (11) durch Führungsflächen begrenzt ist, und dass die Führungsflächen vorzugsweise durch Umbiegungen des als Biegeformteil hergestellten Gegenelements (11) gebildet sind.

9. Baukasten nach einem der Ansprüche 1 bis 8, **dadurch gekennzeichnet, dass** an den aneinander anliegenden Gehäuseseiten (3, 4) der Gehäuse (1, 2) das eine Gehäuse (1) zumindest einen Positioniervorsprung (22) aufweist, der (22) in eine komplementäre Positioniereinformung am anderen Gehäuse (2) eingreift.

10. Baukasten nach einem der Ansprüche 1 bis 9, **dadurch gekennzeichnet, dass** die Gehäuse (1, 2) die Gerätegehäuse einer aus zumindest zwei Geräten zusammengesetzten Datenverarbeitungsanlage sind.

## Claims

1. Modular kit having at least two housings (1,2) which can be releasably connected together by means of at least one connector (5) on adjacent, adjoining sides (3, 4), which connector (5) comprises a connecting element (6) provided on the first housing (1), which element (6) has at least two mutually spaced apart connecting webs (7, 8) having mutually allocated securing openings (9, 10), which connecting webs (7, 8) can be positioned in relation to a counter element (11) provided in the second housing (2) such that a securing splint pin or securing rod (12) pushed into the securing openings (9, 10) penetrates at least one through-channel (13) of the counter element (11) arranged between the connecting webs (7, 8) and is held therein in the axial direction of the connecting webs (7, 8) with adjustable clearance and in a substantially clearance-free manner in a direction oriented at right angles to the securing splint pin or securing rod (12) and to the longitudinal extension of the connecting webs (7, 8), wherein, by reducing the adjustable clearance, the housings (1, 2) can be pressed increasingly against one another and can be securely connected together.

2. Modular kit as claimed in claim 1, **characterised in that** provided in the second housing (2) are guide slots allocated to each connecting web (7, 8) and leading into the region of the at least one counter element (11) arranged in the second housing (2).

3. Modular kit as claimed in claim 1 or 2, **characterised in that** the securing splint pin or securing rod (12) has a ramp contour (14) on its longitudinal edge facing the connecting element (6), **in that** a securing slide (15) is guided in a displaceable manner in the counter element (11) along this longitudinal edge and the ramp contour (14), and **in that** by displacing the securing slide (15) guided in a displaceable manner in the ramp contour (14) the clearance of the securing splint pin or securing rod (12) can preferably be adjusted to zero.

4. Modular kit as claimed in claim 3, **characterised in that** an abutment (16) having a threaded bore (17) is provided on the counter element (11), in which threaded bore (17) an adjustment screw (18) engages, which adjustment screw (18) penetrates a passage opening (19) on the securing slide (15).

5. Modular kit as claimed in any one of claims 1 to 4, **characterised in that** an insert stop (21) is provided on the securing splint pin or securing rod (12), which stop delimits the insert path of the securing splint pin or securing rod (12) in the securing openings (9, 10) and preferably cooperates with the edge region, surrounding the securing opening (9), of the connecting web (7) which is foremost in the insert direction.

6. Modular kit as claimed in any one of claims 1 to 5, **characterised in that** the connecting element (6) and/or the counter element (11) of the at least one connector (5) is produced as a metallic bending moulded part.

7. Modular kit as claimed in claim 6, **characterised in that** the connecting element (6) is produced as a U-shaped bending mould part, the free U-webs of which are formed as connecting webs (7, 8).

8. Modular kit as claimed in claim 6 or 7, **characterised in that** the through-channel (13) of the counter element (11) is delimited by guide surfaces, and **in that** the guide surfaces are preferably formed by bending the counter element (11) produced as a bending moulded part.

9. Modular kit as claimed in any one of claims 1 to 8, **characterised in that** one housing (1) comprises, on the mutually adjoining housing sides (3, 4) of the nousings (1,2), at least one positioning protrusion (22), which protrusion (22) engages into a complementary positioning recess on the other housing (2).

10. Modular kit as claimed in any one of claims 1 to 9, **characterised in that** the housings (1, 2) are the apparatus housings of a data processing system composed of at least two apparatuses.

## Revendications

1. Ensemble modulable comportant au moins deux boîtiers (1, 2), qui peuvent être assemblés l'un à l'autre de façon séparable au moyen d'un connecteur (5) par deux faces voisines adjacentes l'une à l'autre (3, 4), lequel connecteur (5) présente un élément de connexion (6) prévu sur le premier boîtier (1), qui comporte au moins deux barrettes de connexion (7, 8) espacées l'une de l'autre avec des ouvertures de fixation (9, 10) associées l'une à l'autre, lesquelles barrettes de connexion (7, 8) peuvent être positionnées par rapport à un contre-élément (11) prévu dans le deuxième boîtier (2), de telle manière qu'une goupille de fixation ou une barre de fixation (12) introduite dans les ouvertures de fixation (9, 10) traverse au moins un canal de traversée (13) du contre-élément (11) disposé entre les barrettes de connexion (7, 8) et soit maintenue dans celles-ci dans la direction axiale des barrettes de fixation (7, 8) avec un jeu réglable et essentiellement sans jeu dans une direction orientée transversalement à la goupille de fixation ou à la barre de fixation (12) ainsi qu'à l'extension longitudinale des barrettes de fixation (7, 8), dans lequel les boîtiers (1, 2) peuvent être pressés l'un contre d'autre de façon croissante et assemblés l'un à l'autre de façon sûre par une diminution du jeu réglable.

2. Ensemble modulable selon la revendication 1, **caractérisé en ce qu'**il est prévu dans le deuxième boîtier (2) des fentes de guidage respectivement associées à une barrette de connexion (7, 8) et menant dans la région dudit au moins un contre-élément (11) disposé dans la deuxième boîtier (2).

3. Ensemble modulable selon la revendication 1 ou 2, **caractérisé en ce que** la goupille de fixation ou la barre de fixation (12) présente sur son bord longitudinal tourné vers l'élément de connexion (6) un contour extérieur (14), **en ce qu'**un coulisseau de fixation (15) est guidé de façon mobile dans le contre-élément (11) le long de ce bord longitudinal et du contour extérieur (14), et **en ce que** le jeu de la goupille de fixation ou de la barre de fixation (12) peut être réglé, de préférence jusqu'à zéro, par un déplacement du coulisseau de fixation (15) guidé de façon mobile dans le contour extérieur (14).

4. Ensemble modulable selon la revendication 3, **caractérisé en ce qu'**il est prévu sur le contre-élément (11) un appui (16) avec un alésage fileté (17), alésage fileté (17) dans lequel s'engage une vis de réglage (18), qui (18) traverse une ouverture de passage (19) sur le coulisseau de fixation (15).

5. Ensemble modulable selon l'une quelconque des revendications 1 à 4, **caractérisé en ce qu'**il est prévu sur la goupille de fixation ou la barre de fixation (12) une butée d'insertion (21), qui limite le chemin d'insertion de la goupille de fixation ou de la barre de fixation (12) dans les ouvertures de fixation (9, 10), et qui coopère de préférence avec la région de bord entourant l'ouverture de fixation (9) de la barrette de fixation avant (7) dans la direction d'insertion.

6. Ensemble modulable selon l'une quelconque des revendications 1 à 5, **caractérisé en ce que** l'élément de connexion (6) et/ou le contre-élément (11) dudit au moins un connecteur (5) est fabriqué sous la forme d'une pièce façonnée par pliage en métal.

7. Ensemble modulable selon la revendication 6, **caractérisé en ce que** l'élément de connexion (6) est fabriqué sous la forme d'une pièce façonnée par pliage en forme de U, dont les branches libres du U sont réalisées en tant que barrettes de connexion(7, 8).

8. Ensemble modulable selon la revendication 6 ou 7, **caractérisé en ce que** le canal de traversée (13) du contre-élément (11) est limité par des faces de guidage, et **en ce que** les faces de guidage sont formées de préférence par pliage du contre-élément (11) fabriqué sous la forme d'une pièce façonnée par pliage.

9. Ensemble modulable selon l'une quelconque des revendications 1 à 8, **caractérisé en ce que**, sur les côtés de boîtier (3, 4) des boîtiers (1, 2) appliqués l'un contre l'autre, ledit un boîtier (1) présente au moins une saillie de positionnement (22), qui s'engage (22) dans un creux de positionnement complémentaire sur l'autre boîtier (2).

10. Ensemble modulable selon l'une quelconque des revendications 1 à 9, **caractérisé en ce que** les boîtiers (1, 2) sont les boîtiers des appareils d'une installation de traitement de données composée d'au moins deux appareils.
